# EUROPEAN PATENT SPECIFICATION

(11) **EP 3 502 779 B1**
(45) Date of publication and mention of the grant of the patent: **18.11.2020**
(21) Application number: 17002054.9
(22) Date of filing: 21.12.2017
(51) Int. Cl.: G03F 7/00, G03F 7/039, B29C 67/00

(54) **INHERENTLY PHOTODEGRADABLE HYDROGELS OR ORGANOGELS FOR MICROFABRICATION**
INHÄRENT PHOTOABBAUBARE HYDROGELE ODER ORGANOGELE ZUR MIKROFABRIKATION
HYDROGELS OU ORGANOGELS PHOTODÉGRADABLES DE MANIÈRE INHÉRENTE POUR MICROFABRICATION

(43) Date of publication of application: 26.06.2019
(73) Proprietor: Karlsruher Institut für Technologie, 76131 Karlsruhe (DE)
(72) Inventor: Levkin, Pavel, 76344 Eggenstein-Leopoldshafen (DE); LI, Lei, 76227 Karlsruhe (DE)
(74) Representative: Müller-Boré & Partner Patentanwälte PartG mbB

(56) References cited:
- WO-A2-2009/039307
- US-A1- 2014 031 285
- US-B1- 8 343 710
- LEE S H ET AL: "Three-dimensional micropatterning of bioactive hydrogels via two-photon laser scanning photolithography for guided 3D cell migration", BIOMATERIALS, ELSEVIER SCIENCE PUBLISHERS BV., BARKING, GB, vol. 29, no. 20, 1 July 2008 (2008-07-01), pages 2962-2968, XP022647937, ISSN: 0142-9612, DOI: 10.1016/J.BIOMATERIALS.2008.04.004 [retrieved on 2008-04-22]

## Description

The present invention relates to a photodegradable hydrogel or organogel which is used for manufacturing a patterned article, a method for degrading the photodegradable hydrogel or organogel, a corresponding patterned article, as well as the use of such a patterned article in microengineering, e.g. for three-dimensional cell culturing, for drug delivery, or for tissue-engineering.

Hydrogels are water-swollen three dimensional (3D) networks of either physically or chemically crosslinked polymers. Organogels are the organic solvent based analogs of said hydrogels. Hydrogels and organogels possess rich structures and tunable properties, and have become extremely important soft materials useful for both industrial and biomedical fields, including actuators, sensors, artificial muscles, drug delivery, and tissue engineering. To meet these applications, hydrogels and organogels with well-defined microscale structures, including size, shape, porosity and heterogeneity, are usually required. Typical applications of microengineered hydrogels or organogels include, but are not limited to, biomimetic hydrogels/organogels with hierarchical microstructures for tissue engineering, hydrogel/organogel microarrays for high-throughput drug screenings, hydrogel/organogel microarrays as organ-on-a-chip platforms for in-vitro pharmaceutical research, hydrogel/organogel microwell arrays to prepare cell spheroids for 3D culture, hydrogels/organogels with spatially patterned matrix elasticity to direct stem cell fate.

Microengineering hydrogels/organogels can be achieved with various technologies including photolithography, soft-lithography, microfluidics and printing. Photolithography is the most popular method because of its low-cost, high-throughput and ability of large scale patterning. There exist two strategies for photopatterning of hydrogels/organogels: light-triggered cross-linking of pregel mixtures and light-triggered de-cross-linking of photodegradable hydrogels/organogels. The latter strategy shows two apparent advantages: it applies to the photopatterning of hydrogels/organogels with light-sensitive components due to the blocking of UV light by photomasks and it also allows the preparation of hierarchical microstructures within hydrogels/organogels by controlling the photodegradation depth. For achieving the photodegradability, current photodegradable hydrogels/organogels require the introduction of photosensitive groups, like photo-labile o-nitrobenzyl esters and coumarins, photodynamic disulfide and allyl-sulfide, photoresponsive azobenzene-cyclodextrin complex, and iron(III)-carboxylic acid coordination.

However, the introduction of external photosensitive groups inevitably increases the synthetic difficulty and reduces the flexibility and diversity of hydrogel/organogel structures. Accordingly, the scope of their practical applications, including microfabrication, is impeded.

US 8 343 710 B1 describes a photodegradable macromer, comprising: (a) a photodegradable group; (b) a backbone structure comprising one or more repeating units that may be the same or different, which backbone structure is attached to the photodegradable group directly or through a linker; (c) one or more reactive end groups at one or more ends of the macromer; and optionally, (d) one or more therapeutic agents; and optionally (e) one or more caged groups. Also described are polymers and networks incorporating said macromers and optionally other substituents such as other polymeric structures. Also described is a method of controlled degradation of a polymer comprising: providing a described photodegradable polymer and exposing the photodegradable polymer to photoradiation of the appropriate wavelength and energy to cause one or more of the photodegradable groups to photodegrade.

Thus, the technical problem underlying the present invention is to provide a photodegradable hydrogel or organogel, which can be used for preparing patterned articles, can be prepared in a straightforward manner, shows controlled degradation kinetics, has chemical flexibility, and allows sophisticated microfabrication, as well a method for manufacturing a patterned article, which can be used in a diversity of microengineering applications, such as for forming cell aggregates, especially uniform cell aggregates and three-dimensional cell cultures.

The solution to the above technical problem is achieved by the embodiments characterized in the claims.

In particular, the present invention relates to the use of a photodegradable hydrogel or organogel for manufacturing a patterned article by irradiating at least a part of the photodegradable hydrogel or organogel with UV light, the photodegradable hydrogel or organogel comprising a polymer including a three-dimensional network of cross-linked polymer chains,
the polymer chains having repeating units of the general Formula (I) 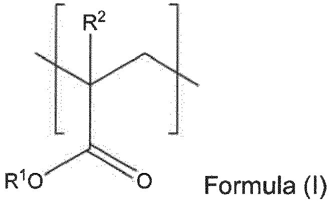
wherein each R¹ is independently selected from the group consisting of a substituted or unsubstituted 2-hydroxyethyl group, a substituted or unsubstituted 2-(N-3-sulfopropyl-N,N-dimethyl ammonium)ethyl group, and a substituted or unsubstituted poly(ethylene glycol) alkyl ether group selected from a PEG106 to PEG20000 group; and
each R² is independently a hydrogen atom or a substituted or unsubstituted alkyl group; and
wherein the photodegradable hydrogel or organogel does not comprise external photosensitive groups, photoinitiators or thiols.

Herein, the term "photodegradable hydrogel or organogel" relates to a hydrogel or organogel which can be degraded when subjected to light irradiation. Upon light irradiation, the three-dimensional network of cross-linked polymer chains preferably breaks up. This leads to a change in the consistency of the former hydrogel/organogel to a liquid state, which can subsequently be removed, e.g. by washing with water or solvent.

If not stated otherwise, the following definitions apply to the terms "alkyl group", "alkylene group", "cycloalkyl group", "aryl group", and "heteroaryl group". The term "alkyl group" refers particularly to a branched or linear alkyl group having 1 to 20, preferably 1 to 12, more preferably 1 to 6, and most preferably 1 to 4 carbon atoms, which can be substituted or unsubstituted. Examples of alkyl groups represent methyl groups, ethyl groups, propyl groups, isopropyl groups, butyl groups, isobutyl groups, tert-butyl groups, pentyl groups, hexyl groups, and heptyl groups. The term "alkylene group" refers particularly to a branched or linear alkylene group having 5 to 2000, preferably 10 to 1000, and most preferably 20 to 500 carbon atoms, which can be substituted or unsubstituted. The term "cycloalkyl group" refers particularly to a cycloalkyl group having 3 to 10, preferably 4 to 8, more preferably 5 or 6, and most preferably 6 carbon atoms, which can be substituted or unsubstituted. Examples of cycloalkyl groups represent cyclobutyl groups, cyclopentyl groups, and cyclohexyl groups. The term "aryl group" refers particularly to an aryl group consisting of 1 to 6, preferably 1 to 4, more preferably 1 to 3 aromatic rings, and most preferably 1 aromatic ring, which can be substituted or unsubstituted. Examples of aryl groups represent phenyl groups, anthracenyl or naphthyl groups. The term "heteroaryl group" refers particularly to a heteroaryl group consisting of 1 to 6, preferably 1 to 4, more preferably 1 to 3 aromatic rings including heteroatoms, which can be substituted or unsubstituted. Heteroatoms, which are present in heteroaryl groups are for example N, O and S. Examples of heteroaryl groups represent pyridyl groups, pyrimidinyl groups, thienyl groups, furyl groups or pyrrolyl groups.

The alkyl groups, the alkylene groups, the cycloalkyl groups, the aryl groups and the heteroaryl groups may be substituted or unsubstituted. The potential substituents are not specifically limited. Accordingly, instead of hydrogen atoms any substituent known in the prior art can be bonded to the further positions of the corresponding groups. For example, the potential substituents may be selected from the group consisting of a branched or linear alkyl group having 1 to 6 carbon atoms, a cycloalkyl group having 4 to 8 carbon atoms, an aryl group having 1 to 3 aromatic rings, a heteroaryl group having 1 to 3 aromatic rings including heteroatoms, a halogen atom, -NL¹L², -NO₂, -CN, -OL³, -C(O)L⁴, -C(O)NL⁵L⁶, -COOL⁷, and -SO₃L⁸, wherein L¹ to L⁸ are each independently selected from a hydrogen atom, a branched or linear alkyl group having 1 to 6 carbon atoms, a cycloalkyl group having 4 to 8 carbon atoms, an aryl group having 1 to 3 aromatic rings, a heteroaryl group having 1 to 3 aromatic rings including heteroatoms. Accordingly, examples of substituted alkyl groups are aralkyl groups or alkyl groups substituted with e.g. cycloalkyl groups or alkyl groups substituted with e.g. halogen atoms, such as e.g. a trifluoromethyl group or a trichloromethyl group, or any other of the above-mentioned substituents. Preferably, the potential substituents are selected from the group consisting of a branched or linear alkyl group having 1 to 6 carbon atoms, an aryl group having 1 to 3 aromatic rings, a heteroaryl group having 1 to 3 aromatic rings including heteroatoms, -NH₂, -NHCH₃, -N(CH₃)₂, -NO₂, -OH, -OCH₃, - OEt, -C(O)H, and -COOH. Moreover, one or more tetravalent carbon atoms (together with the hydrogen atoms bonded thereto), when present, in each of the alkyl groups, the alkylene groups, and the cycloalkyl groups may each independently be substituted by a member selected from the group consisting of O, (OCH₂CH₂)ₚO, S, (SCH₂CH₂)_{q}S, C(O), C(O)O, NX, and C(O)NY, preferably O, (OCH₂CH₂)ₚO, C(O)O, and C(O)NY, wherein p and q are each independently an integer from 1 to 6. Accordingly, for example an alkyl group may be interrupted by e.g. one or more poly(ethylene glycol) (PEG) linkers and/or amide bonds. The way the groups are introduced instead of a carbon atom is not specifically limited. For example, a carbon atom may be substituted by C(O)O in the sense of -C(O)O- or -OC(O)- and by C(O)NY in the sense of -C(O)NY-or -NYC(O)-. X and Y are each independently selected from the group consisting of a hydrogen atom, a branched or linear alkyl group having 1 to 6 carbon atoms, a cycloalkyl group having 4 to 8 carbon atoms, an aryl group having 1 to 3 aromatic rings, a heteroaryl group having 1 to 3 aromatic rings including heteroatoms, -OZ¹, -C(O)Z², -C(O)NZ³Z⁴, -COOZ⁵, and -SO₂Z⁶. In a preferred embodiment, X and Y are each independently selected from the group consisting of a hydrogen atom, a branched or linear alkyl group having 1 to 6 carbon atoms, an aryl group having 1 to 3 aromatic rings, -C(O)Z², and -SO₂Z⁶. Most preferably, X and Y are each independently selected from the group consisting of a hydrogen atom and a branched or linear alkyl group having 1 to 6 carbon atoms. Z¹ to Z⁶ are each independently selected from the group consisting of a hydrogen atom, a branched or linear alkyl group having 1 to 6 carbon atoms, a cycloalkyl group having 4 to 8 carbon atoms, an aryl group having 1 to 3 aromatic rings, a heteroaryl group having 1 to 3 aromatic rings including heteroatoms. In a preferred embodiment, Z¹ to Z⁶ are each independently selected from the group consisting of a hydrogen atom, a branched or linear alkyl group having 1 to 6 carbon atoms, and an aryl group having 1 to 3 aromatic rings.

Most preferably, the alkyl groups, the alkylene groups, the cycloalkyl groups, the aryl groups and the heteroaryl groups are unsubstituted. Moreover, in a preferred embodiment the alkyl groups and the alkylene groups are linear.

The photodegradable hydrogels or organogels used in the present invention are inherently photodegradable hydrogels or organogels, which do not comprise external photosensitive groups as described above and do not comprise additional chemicals, such as e.g. photoinitiators or thiols, for the degradation. Herein, the term "external photosensitive groups" relates to photosensitive groups other than those included in the backbone of the polymer chains having the repeating units of the general Formula (I). The backbone of said polymer chains does not include the groups R¹. Thus, photosensitive groups may not be included in said groups R¹. In particular, it is not necessary to include external photosensitive groups, as e.g. photo-labile o-nitrobenzyl esters and coumarins, photodynamic disulfide and allyl-sulfide, photoresponsive azobenzene-cyclodextrin complex, and iron(III)-carboxylic acid coordination.

The photodegradable hydrogels or organogels used in the present invention can e.g. be developed from poly(meth)acrylate hydrogels/organogels. Poly(meth)acrylates are photodegradable due to the homolysis of main chain carbon-carbon bonds under UV light. According to a proposed non-limiting mechanism, this photolysis process undergoes three routes: the direct main-chain scission, the main-chain scission following side-chain scission, and the photooxidative main chain scission. Without being bound to a specific theory, it is hypothesized that the photolysis of poly(meth)acrylate will lead to the de-cross-linking of the corresponding hydrogels/organogels, without external photosensitive groups being required.

According to the present invention, the polymer chains have repeating units of the general Formula (I) 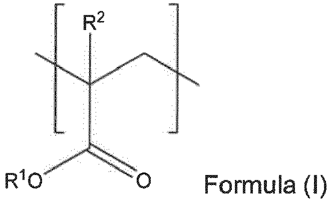 wherein each R¹ is independently selected from the group consisting of a substituted or unsubstituted 2-hydroxyethyl group, a substituted or unsubstituted 2-(N-3-sulfopropyl-N,N-dimethyl ammonium)ethyl group, and a substituted or unsubstituted poly(ethylene glycol) alkyl ether group selected from a PEG106 to PEG20000 group; and each R² is independently a hydrogen atom or a substituted or unsubstituted alkyl group.

The 2-hydroxyethyl group, the 2-(N-3-sulfopropyl-N,N-dimethyl ammonium)ethyl group, and the poly(ethylene glycol) alkyl ether group of R¹ may be further substituted. The above definition concerning potential substituents analogously applies to the potential further substituents of the 2-hydroxyethyl group, the 2-(N-3-sulfopropyl-N,N-dimethyl ammonium)ethyl group, and the poly(ethylene glycol) alkyl ether group of R¹. Preferably, the 2-hydroxyethyl group, the 2-(N-3-sulfopropyl-N,N-dimethyl ammonium)ethyl group, and the poly(ethylene glycol) alkyl ether group of R¹ are not further substituted.

The term "poly(ethylene glycol) group" refers to PEG molecules, wherein one terminal hydrogen has been abstracted. Preferably, the term "poly(ethylene glycol) group" refers to corresponding PEG molecules (i.e. PEG molecules, wherein one terminal hydrogen has been abstracted) derived from PEG molecules (with all hydrogen atoms) within the Mn range of 106 to 20000, preferably of 200 to 1200, more preferably of 300 to 800 group, more preferably of 400 to 700, most preferably from PEG molecules (with all hydrogen atoms) with a Mn of 500.

The term "poly(ethylene glycol) alkyl ether group" refers to PEG molecules, wherein one terminal hydrogen has been exchanged for an alkyl group, preferably a branched or linear alkyl group having 1 to 10 carbon atoms, more preferably a methyl or an ethyl group, most preferably a methyl group, and another hydrogen of the poly(ethylene glycol) molecule, preferably the other terminal hydrogen, is abstracted. Moreover, the terms "a PEGX¹00 to PEGY¹00 group" herein mean PEG alkyl ether groups, preferably PEG methyl ether groups, derived from PEG molecules (with all hydrogen atoms) within the Mn range of X¹00 to Y¹00. Accordingly, the term "PEGX¹00MA to PEGY¹00MA" refers to poly(ethylene glycol) methacrylates having PEG alkyl ether groups, preferably PEG methyl ether groups, derived from PEG molecules (with all hydrogen atoms) within the Mn range of X¹00 to Y¹00.

Herein, if not stated otherwise, in case a poly(ethylene glycol) group or a poly(ethylene glycol) alkyl ether group is attached (e.g. in a general formula, such as e.g. in the case of R¹ in general Formulas (I) and (II)) to a oxygen atom, said oxygen belongs to the poly(ethylene glycol) group or the poly(ethylene glycol) alkyl ether group, respectively.

Furthermore, the term "poly(ethylene glycol) linker group" refers to PEG molecules, wherein both terminal hydrogens have been abstracted. The term "PEGX²00D(M)A to PEGY²00D(M)A" refers to poly(ethylene glycol) di(meth)acrylates having PEG linker groups derived from PEG molecules (with all hydrogen atoms) within the Mn range of X²00 to Y²00.

In case the polymer comprises repeating units of the general Formula (I) having more than one kind of R¹ and/or R² groups, the mass ratios of the different repeating units are not particularly limited. Thus, the different repeating units may be mixed in any given ratio as long as the hydrogel/organogel keeps its photodegradable properties. Preferably, the polymer comprises repeating units of the general Formula (I) having only one kind of R¹ group and one kind of R² group.

In case the polymer comprises repeating units of the general Formula (I) wherein R¹ is a 2-hydroxyethyl group, the polymer preferably further contains repeating units of the general Formula (I) wherein R¹ is a poly(ethylene glycol) alkyl ether group, preferably a PEG500 group. In case the polymer comprises repeating units of the general Formula (I) wherein R¹ is a 2-hydroxyethyl group, the polymer preferably further contains 20 mol% or more of repeating units of the general Formula (I) wherein R¹ is a poly(ethylene glycol) alkyl ether group, preferably a PEG500 group, based on a total of 100 mol% of the repeating units of the general Formula (I).

In a preferred embodiment, each R¹ is independently selected from the group consisting of a 2-hydroxyethyl group, a 2-(N-3-sulfopropyl-N,N-dimethyl ammonium)ethyl group, and a poly(ethylene glycol) alkyl ether group selected from a PEG106 to PEG20000 group. More preferably, each R¹ is independently a poly(ethylene glycol) alkyl ether group selected from a PEG106 to PEG20000 group, preferably from a PEG200 to PEG1200 group. Even more preferably, each R¹ is independently a poly(ethylene glycol) alkyl ether group selected from a PEG300 to PEG800 group, more preferably a poly(ethylene glycol) alkyl ether group selected from a PEG400 to PEG700 group, most preferably each R¹ is a PEG500 group.

In a preferred embodiment, each R² is independently an alkyl group having 1 to 4 carbon atoms. Most preferably, R² is a methyl group.

The cross-linking agent used for cross-linking the polymer chains of the polymer comprised in the photodegradable hydrogel or organogel used in the present invention is not particularly limited. In a preferred embodiment, the cross-linking agent used for cross-linking the polymer chains has the general Formula (III) 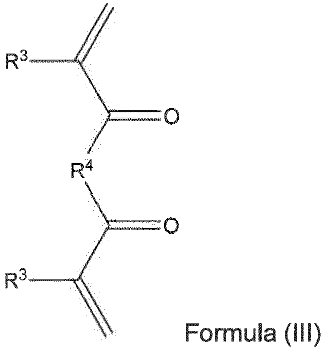 wherein each R³ is independently selected from the group consisting of a hydrogen atom, a substituted or unsubstituted alkyl group, a substituted or unsubstituted cycloalkyl group, a substituted or unsubstituted aryl group, and a substituted or unsubstituted heteroaryl group; and R⁴ is selected from a substituted or unsubstituted alkylene group, a substituted or unsubstituted poly(ethylene glycol) linker group, and the following Formula (IV) 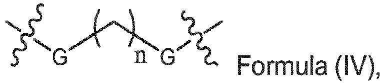 wherein G is NH or an oxygen atom and n is an integer from 1 to 5.

Accordingly, when the cross-linking agent has the general Formula (III) the main chains are cross-linked via cross-linking units of the general Formula (V)

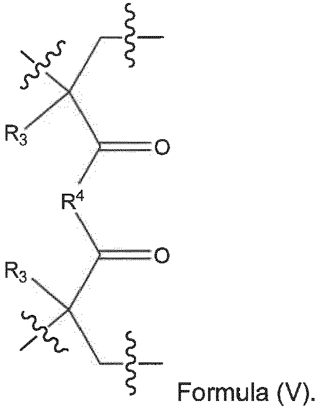

The above definitions with respect to R³ and R⁴ analogously apply to the cross-linking units of the general Formula (V).

According to the present invention, n is an integer from 1 to 5. Thus, the corresponding alkylene group in Formula (IV) may be a methylene group, an ethylene group, a propylene group, a butylene group, or a pentylene group, which may be substituted or unsubstituted. Preferably, n is an integer from 1 to 3, more preferably an integer of 1 or 2. When G is NH, n is most preferably 1, i.e. the corresponding alkylene group in Formula (IV) is a methylene group. When G is an oxygen atom, n is most preferably 2, i.e. the corresponding alkylene group in Formula (IV) is an ethylene group.

In a preferred embodiment, G is an oxygen atom.

The poly(ethylene glycol) linker group and the alkylene group in Formula (IV) of R⁴ may be further substituted. The above definition concerning potential substituents analogously applies to the potential (further) substituents of the poly(ethylene glycol) linker group and the alkylene group in Formula (IV) of R⁴. Preferably, the poly(ethylene glycol) linker group and the alkylene group in Formula (IV) of R⁴ are not (further) substituted.

In a particularly preferred embodiment, the cross-linking agent is selected from the group consisting of ethylene glycol dimethacrylate (EGDMA), *N,N'-*methylenebisacrylamide (MBA), poly(ethylene glycol) diacrylate selected from PEG106DA to PEG20000DA, preferably from PEG300DA to PEG1500DA, and poly(ethylene glycol) dimethacrylate selected from PEG106DMA to PEG20000DMA, preferably from PEG500DMA to PEG6000DMA. Most preferably, PEG700DA and PEG4000DMA are used due to their good water-solubility and commercial availability.

The content of the cross-linked polymer in the hydrogel or organogel used in the present invention is not particularly limited. For example, the content of the polymer in the hydrogel or organogel may be from 2.0 to 40 wt%, preferably from 5.0 to 35 wt%, more preferably from 10 to 30 wt%, and most preferably from 15 to 25 wt%. The remainder is water or the respective organic solvent and optional additives as well as potential impurities included e.g. due to the manufacturing process, such as remainder of the redox initiators used in redox-initiated radical copolymerization. The optional additives are not particularly limited and are known in the art. For example, as additive there may be used Rhodamine B for fluorescence imaging.

In a preferred embodiment, the photodegradable hydrogel or organogel used in the present invention is transparent.

The method for producing the photodegradable hydrogel or organogel used in the present invention is not particularly limited. Thus, any known method for producing hydrogels/organogels can be used. For example, the hydrogel or organogel may be produced by polymerizing the monomer units in water and/or the respective organic solvent in the presence of a cross-linking agent or crosslinking the poly(meth)acrylates in water and/or the respective organic solvent via the reaction of side groups. In a preferred embodiment of the present invention, the hydrogel or organogel used in the present invention is produced by a method comprising the step of polymerizing monomer units of the general Formula (II) 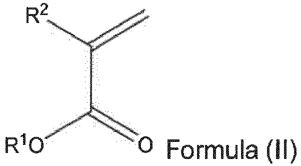 in water and/or the respective organic solvent in the presence of a cross-linking agent. The above statements and definitions analogously apply to said method for producing the hydrogel or organogel according to the present invention. Preferably, the monomer units are selected from the group consisting of (2-hydroxyethyl)methacrylate, [2-(methacryloyloxy)ethyl]dimethyl-(3-sulfopropyl) ammonium hydroxide, and poly(ethylene glycol) alkyl ether methacrylates selected from PEG106MA to PEG20000MA, preferably from PEG200MA to PEG1200MA. More preferably, the monomer units are selected from poly(ethylene glycol) alkyl ether methacrylates selected from PEG106MA to PEG20000MA, preferably from PEG200MA to PEG1200MA. Most preferably, the monomer units are PEG500 methyl ether methacrylate.

The polymerization method is not particularly limited. Thus, any known polymerization method can be used. For example, the polymer may be produced by redox-initiated radical copolymerization, photo-initiated radical polymerization or thermo-initiated radical polymerization. Preferably the polymer is produced by redox-initiated radical copolymerization due to the fast kinetics and easy operation associated with said method.

When using redox-initiated radical copolymerization, the applied redox initiators are not particularly limited. Thus, any known redox initiators can be used. For example, as redox initiators there may be used a combination of ammonium persulfate (APS) and *N*,*N*,*N'*,*N*'-tetramethylethylenediamine (TEMED), or benzoyl peroxide and *N,N-*dimethylaniline. Preferably, as redox initiator there is used a combination of ammonium persulfate and *N*,*N*,*N*',*N*'-tetramethylethylenediamine. For example, the concentration of the redox initiator in the polymerization medium may be from 1.0 mM to 200 mM, preferably from 3.0 mM to 100 mM, more preferably from 6.0 mM to 30 mM. When using a combination of ammonium persulfate and *N*,*N*,*N'*,*N'-*tetramethylethylenediamine as redox initiator the respective concentrations in the polymerization medium may be from 1.0 mM to 100 mM for ammonium persulfate and from 1.3 mM to 130 mM for *N*,*N*,*N*',*N*'-tetramethylethylenediamine, preferably from 4.0 mM to 25 mM for ammonium persulfate and from 5.2 mM to 33 mM for *N*,*N*,*N'*,*N'-*tetramethylethylenediamine, more preferably 8.0 mM to 12 mM for ammonium persulfate and from 10 mM to 16 mM for *N*,*N*,*N*',*N*-tetramethylethylenediamine. Higher concentrations of ammonium persulfate and *N,N,N',N'*-tetramethylethylenediamine will lead to faster gelations.

The total amount of the monomer units and the cross-linking agent in the reaction medium is not particularly limited. For example, total amount of the monomer units and the cross-linking agent (taken together) in the reaction medium may be from 2.0 to 40 wt%, preferably from 5.0 to 35 wt%, more preferably from 10 to 30 wt%, and most preferably from 15 to 25 wt%.

The mole fraction of the cross-linking agent used is not particularly limited. For example, the mole fraction of the cross-linking agent used may be from 0.10% to 20%, preferably from 1.0% to 15%, and most preferably from 2.5% to 10%, based on the total amount of the monomer units and the cross-linking agent.

The reaction medium is not particularly limited as long as it dissolves the obtained polymers. For example, the medium may be water, a medium based on one or more organic solvents, or a medium based on a mixture of water with one or more organic solvents. Suitable solvents are for example water, tetrahydrofuran, dimethylformamide, and dimethyl sulfoxide, which are able to dissolve both monomer and polymer to a satisfactory extent. Preferably, the reaction medium is water (i.e. leading to a hydrogel).

The reaction temperature is not particularly limited. For example, the reaction temperature may be from -20°C to 100°C, preferably from 0°C to 80°C, more preferably from 20°C to 60°C, and most preferably from 25°C to 40°C.

The reaction/gelation time is not particularly limited. For example, the reaction/gelation time may be from 1 min to 10 h, preferably from 5 min to 5 h, more preferably from 5 min to 3 h, and most preferably from 5 min to 60 min.

The substrates on which the hydrogel or organogel may be applied is not particularly limited. For example, the substrate may be selected from glass, metal, plastic, or an elastomer. Suitable plastics are for example polystyrene, polyethylene, poly(methyl methacrylate), and poly(ethylene terephthalate). Suitable elastomers are for example polyisoprene, polybutadiene, polychloroprene, polysiloxanes, polyurethane, and fluoro-elastomers.

The hydrogel or organogel used in the present invention can degrade when irradiated with UV light, e.g. light having a wavelength from 100 nm to 300 nm, preferably from 200 to 300 nm, more preferably from 240 to 280 nm, e.g. UV light having a wavelength of 260 nm. Accordingly, the patterned article is formed by irradiating at least a part of the photodegradable hydrogel or organogel with such UV light.

An excellent precision can preferably be reached by manufacturing a patterned article with the photodegradable hydrogel or organogel used in the present invention. For example, the fabrication can reach a precision in the micrometer range, e.g. approx. 20 µm, and thus can be regarded as microfabrication. Moreover, free-standing and shaped hydrogel/organogel particles can be obtained e.g. in case no covalent bonding between substrates and hydrogels/organogels are present.

The intensity of the light used when irradiating the photodegradable hydrogel or organogel is not particularly limited. For example, the light may have an intensity from 0.1 mW/cm² to 1000 mW/cm², preferably from 0.1 mW/cm² to 25 mW/cm², more preferably from 1.0 mW/cm² to 10 mW/cm², more preferably from 2.0 mW/cm² to 7.0 mW/cm², and most preferably from 3.0 mW/cm² to 5.0 mW/cm².

The irradiation time is not particularly limited. In general, the irradiation time depends on the light intensity and the hydrogel/organogel thickness, and ranges from minutes to hours. For example, the irradiation time may be from 30 s to 2.5 h, preferably from 1.0 min to 1.0 h, more preferably from 2.0 min to 30 min, and most preferably from 3.0 min to 10 min.

Optionally, there may be included a washing step after irradiation. By applying said washing step, degraded parts of the hydrogel/organogel can be removed. Preferably, water or organic solvents are used for said washing step. Most preferably, water and/or the respective organic solvent building the basis of the hydrogel/organogel are used for the washing step.

Herein, the term "patterned article" relates to a partially (photo)degraded hydrogel or organogel. Apart from that the patterned article is obtained from the photodegradable hydrogel or organogel, it is not particularly limited. Thus, any patterned article, which can be produced from the photodegradable hydrogel or organogel is encompassed by the present invention. Appropriate shapes and patterns can for example be obtained by the application of photomasks when irradiating the photodegradable hydrogel or organogel. For example, the patterned article may be any micro-device, such as a microwell array or microchannel, or any three-dimensional structure, which may be complex, or a particle, which may be free-standing, or any article with a pattern. Preferably, the patterned article is a microwell array.

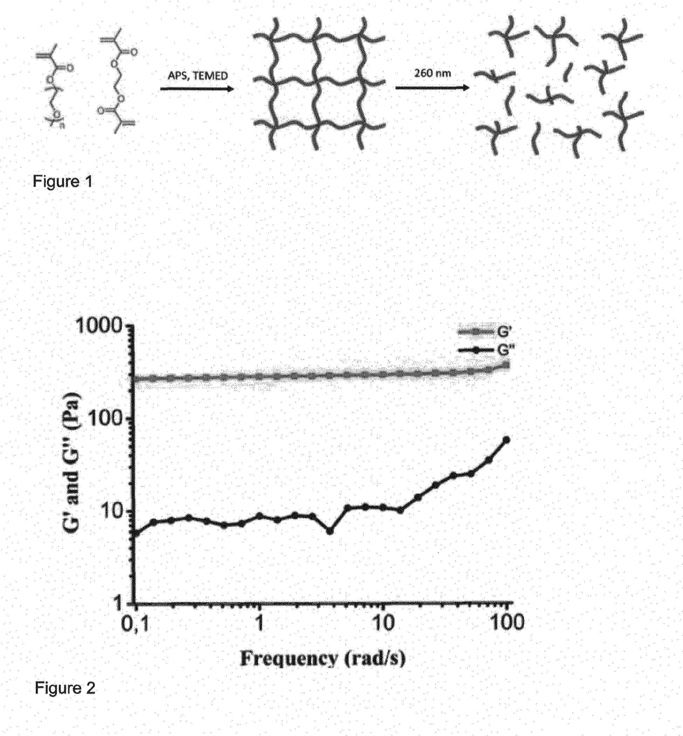

One specific example of a photodegradable hydrogel used in the present invention is poly(ethylene glycol) methyl ether methacrylate (Mn 500, PEG500MA) crosslinked with ethylene glycol dimethacrylate (EGDMA). The PEG500MA-EGDMA-10 hydrogel can be obtained via redox polymerization (Figure 1) and was characterized with rheology measurement. The PEG500MA-EGDMA-10 hydrogel and other hydrogels/organogels herein are named as "monomer-cross-linking agent-X", where X % equals to n_{cross-linking} agent/(n_{cross-linking} agent + nₘₒₙₒₘₑᵣ), with the concentration of monomer and cross-linking agent fixed at 20 wt% for comparison. However, the photodegradable hydrogel or organogel used in the present invention is not limited to a corresponding concentration of monomer and cross-linking agent as mentioned above.

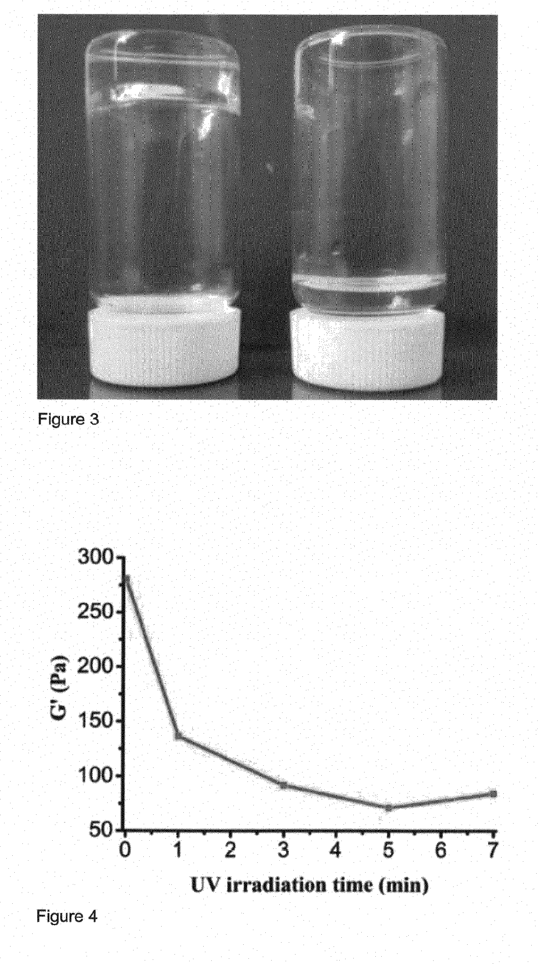

As shown in Figure 2, the storage modulus (G') of PEG500MA-EGDMA-10 hydrogels is larger than the loss modulus (G") and both of them show independence on frequencies, demonstrating the formation of hydrogels. In case one 3.5 mm-thick block of this hydrogel is exposed to UV light (260 nm, 5 mW/cm²), said hydrogel block completely turns into liquid state after 25 min (Figure 3), which demonstrates that this PEG500MA-EGDMA-10 hydrogel can be de-crosslinked under UV-irradiation. Further rheology measurements were used to monitor the photodegradation process (Figure 4). During the UV irradiation, the G' of the hydrogel gradually decreases from 280 Pa to 84 Pa, being about 30 % of the original storage modulus (G'₀), during the exposure for 7 min (Figure 4). Longer irradiation leads to the total degradation of hydrogels. All these data demonstrate the inherent photodegradability of a PEG500MA-EGDMA-10 hydrogel.

New inherently photodegradable hydrogels/organogels were developed by taking advantage of the photolysis property of e.g. poly(meth)acrylates. This strategy enables the straightforward preparation of photodegradable hydrogels/organogels without requiring external photosensitive groups or additional chemicals for degradation of the same, and generally tolerates various monomers and cross-linking agents. The defined kinetics and spatial controllability of the photodegradation process and the robustness of the photodegradable hydrogels or organogels used in the present invention advantageously provides a convenient way to fabricate sophisticated hydrogel/organogel microstructures via the photolithography technique. In particular, these photodegradable hydrogels/organogels provide convenient access to microstructured platforms e.g. for the culturing of cells. Especially, the photodegradable hydrogel or organogel used in the present invention provides two advantages, i.e. capacity to prepare microwells with defined geometry and dimensions, as well as resistance to cell adhesion due to the bio-inertness of hydrophilic PEG chains.

In a further aspect, the present invention relates to a method for degrading a photodegradable hydrogel or organogel comprising the step of irradiating at least a part of the photodegradable hydrogel or organogel used in the present invention with UV light, e.g. light having a wavelength from 100 nm to 300 nm, preferably from 200 to 300 nm, more preferably from 240 to 280 nm, e.g. UV light having a wavelength of 260 nm. The above statements and definitions analogously apply to this aspect of the present invention.

In a further aspect, the present invention relates to a patterned article obtained by the use according to the present invention or the method for degrading a photodegradable hydrogel or organogel according to the present invention. The above statements and definitions analogously apply to this aspect of the present invention.

Preferably, the patterned article is a microwell array. The dimensions of the microwell array are not particularly limited. For example, the height of the microwell array may be from 1 to 1000 µm, the breadth of the microwell array may e.g. be from 20 to 1000 µm, and the depth of the microwell array may e.g. be from 1 to 1000 µm.

The photodegradable hydrogels or organogels used in the present invention provide convenient access to microstructured platforms. Such micropatterned hydrogels/organogels can e.g. be used for the formation of 3D multicellular aggregates, an important 3D model for cell cultures. These 3D cell cultures are important for understanding cellular behaviors and can e.g. be used in cell study, drug screening, tissue engineering. Compared with the traditional two-dimensional (2D) models, 3D models better mimic both chemical and physical cues of native cellular microenvironment in vivo and allows the cell-cell and cell-ECM signaling, which greatly affect cell growth, proliferation, differentiation, and other cellular functions. Furthermore, the photodegradable hydrogels or organogels used in the present invention are for example able to provide access to corresponding particles, which might be used for drug delivery, preferably into a mammal, more preferably into a human, to three-dimensional structures, which might also have complex shapes and/or which might be used for tissue-engineering, in particular *in vitro,* or to corresponding objects with specific patterns. In the case of structures for tissue-engineering, these structures may or may not contain cells.

Therefore, in a further aspect, the present invention relates to the use of the patterned article according to the present invention in all kinds of microengineering, e.g. for three-dimensional cell culturing, for drug delivery, or for tissue-engineering, preferably three-dimensional cell culturing. The above statements and definitions analogously apply to this aspect of the present invention. In this context, three-dimensional cell culturing means the culturing of cells in such a way that the cells are permitted to grow or interact with their surroundings in all three dimensions.

The respective method used for three-dimensional cell culturing, for drug delivery, or for tissue-engineering is not particularly limited as long as the patterned article according the present invention is used for the same. For example, one method for three-dimensional cell culturing may comprise seeding cells in the patterned article, preferably a microwell array, and culturing the seeded cells. Optionally, such a method may further comprise washing the patterned article after seeding the cells therein and before culturing the seeded cells. By applying said washing step, excess cells outside e.g. cavities can be removed. Preferably, phosphate buffered saline (PBS) is used for said washing step.

The cells may for example be seeded in cavities of the patterned article, such as e.g. microwells of a microwell array. Thereby, the number of cells present in each of the cavities upon seeding is not particularly limited. For example, the number of cells present in each of the cavities may be from 1 to 50 cells. Preferably, the number of cells present in each of the cavities upon seeding is from 3 to 30 cells, more preferably from 5 to 15 cells, to permit the direct observation and monitoring of cell proliferation.

Within the scope of the invention, the term "cells" means a generic term and encompasses individual cells, insect cells, avian cells, mammalian cells, bacterial cells, primary cells, cancer cells, continuous cell lines, stem cells and/or genetically engineered cells, such as recombinant cells expressing a heterologous polypeptide or protein and/or containing a recombinant nucleic acid molecule and/or stable expressing cells. Preferably, the cells are Hela cells.

The culturing time is not particularly limited. For example, the cells may be cultured for 12 h to 30 d, preferably for 1.0 d to 15 d, and more preferably for 3.0 d to 10 d, e.g. for 7d.

The culturing temperature is not particularly limited. For example, the culturing temperature may be from 5°C to 40°C, preferably from 10°C to 39°C, more preferably from 15°C to 38°C, and most preferably from 20°C to 37°C.

The culture medium is not particularly limited. Thus, any known culture medium known in the art can be used. For example, the culture medium may be an aqueous medium, a medium based on one or more organic solvents, or a medium based on a mixture of water with one or more organic solvents. The culture medium may e.g. contain salts and substrates and may have a specific pH. For example, enzyme substrates and co-substrates, buffer components, nutrients for growth of cells, antibodies, and proteins may be comprised in the medium. Preferably, the medium is selected from the group consisting of water, phosphate buffered saline (PBS), Dulbecco's Modified Eagle's Medium. Preferably, the culture medium is PBS having a pH of 7.4.

It has been demonstrated that photodegradable hydrogels or organogels used in the present invention are robust photodegradable scaffolds. This photodegradation system shows apparent advantages, that is, straightforward fabrication, controlled erosion kinetics, flexible chemical variety, and robustness for microscale photofabrication. Moreover, the hydrogel/organogel microwell array developed represents a sophisticated 3D cell culture platform, in particular due to excellent cytocompatibility of the hydrogel/organogel. These inherently photodegradable hydrogels or organogels can e.g. be used for fabrication of microstructured materials in cell culture, microfluidics devices, and tissue engineering. A corresponding microwell array is preferably able to form cell aggregates, especially uniform cell aggregates and three-dimensional cell cultures.

The figures show:
Figure 1: Photodegradable hydrogel/organogel synthesis and degradation. The hydrogel/organogel network is formed via the redox copolymerization of PEG500MA and EGDMA initiated by APS and TEMED. The obtained hydrogel/organogel is decrosslinked due to the photolysis of carbon-carbon bonds in the polymethacrylate backbone upon exposure to UV light.
Figure 2: Elastic (G') and viscous (G") moduli of PEG500MA-EGDMA-10 hydrogels.
Figure 3: A 3.5 mm-thick PEG500MA-EGDMA-10 hydrogel was irradiated with 260 nm light (5 mW/cm²), and completed eroded over the course of ≈25 min.
Figure 4: Plots of G' versus UV irradiation time. Evidence for the hydrogel degradation can be seen from the decreasing of G' with the irradiation time.
Figure 5: Progressively recessed features of hydrogels upon irradiation. The PEG500MA-EGDMA-10 hydrogel was eroded spatially through masked irradiation (260 nm, 5 mW/cm²). After non-specific adsorption of Rhodamine B, these patterned hydrogels were imaged with confocal microscopy. Erosion depth increased with irradiation time. Scale bar: 200 µm.
Figure 6: Photodegradation kinetics of the PEG500MA-EGDMA-10 hydrogel can be adjusted by changes in light intensity. The increase in photodegradation depths with increasing irradiation time was fastened when increasing the UV light intensity from 3 mW/cm² to 5 mW/cm².
Figure 7: Effects of cross-linking agents on photodegradation kinetics. Photodegradation processes were monitored for the PEG500MA hydrogels (20 wt%) with 2.5 mol% EGDMA, MBA, or PEG700DA as cross-linking agents. Higher crosslinking degrees caused by cross-linking agents having better water-solubility and longer chain length led to slower photodegradation kinetics. For the hydrogel with PEG4000DMA as the cross-linking agents, the amount of the cross-linking agent was further decreased to 0.17 mol% in order to reach the apparent photodegradation kinetics under the same condition.
Figures 8 and 9: Photodegradation kinetics of a (HEMA80mol%-PEG500MA20mol%)-EGDMA-0.85 hydrogel (Figure 8) and of a SAMA-EGDMA-2.5 hydrogel (Figure 9).
Figure 10: Hydrogel microarrays and microcavities of different geometries were fabricated via UV irradiation of 125 µm-thick PEG500MA-EGDMA-10 hydrogels through corresponding photomasks. Their 2D geometries were shown in the fluorescence images (top panel) and their 3D shapes were confirmed in the confocal images (bottom panel).
Figures 11 and 12: Hydrogel patterns of different geometries were fabricated via UV irradiation of 125 µm-thick (HEMA80mol%-PEG500MA20mol%)-EGDMA-0.85 hydrogels (Figure 11) and 125 µm-thick SAMA-EGDMA-2.5 hydrogels (Figure 12) through corresponding photomasks. Their 2D geometries were shown in the fluorescence images and their 3D shapes were confirmed in the inserted images.
Figure 13: Brightfield microscope images of 12.5 µm-thick PEG500MA-EGDMA-10 hydrogel patterns with lines of different widths. The precision of this microfabrication could reach as small as 20 µm.
Figure 14: Free-standing and shaped hydrogel particles were obtained from a 125 µm-thick PEG500MA-PEG4000DMA-0.17 hydrogel as model hydrogel in case of no covalent bonding between substrates and hydrogels. These patterns still possess photodegradability. Scale bars are 500 µm.
Figure 15: Microcavities are fabricated by the UV patterning of photodegradable PEG500MA-PEG700DA-2.5 hydrogel (125 µm-thick). After seeding on the microcavities array, cells are allowed to settle within the microcavities. Subsequently gentle washing removes extraneous cells outside of the microcavities, thus selectively trapping cells inside. The sidewalls and bottom of these microcavities are PEG hydrogels, which are cell-repellant and non-adhesive, thus preventing cell adhesion and helping to encourage cells to "clump together" and to form aggregates.
Figure 16: Bright images showing that cells were perfectly trapped within the circle microcavities. During the 7-day incubation, cells proliferate and form into dense aggregates, showing the same circle shape. Scale bars: 100 µm.
Figure 17: Confocal image confirming the 3D shape of microcavities with the diameter of 100 µm and the thickness of 60 µm. Scale bars: 100 µm.
Figure 18: After 7-day incubation within the microcavities, cell nuclei and dead cells were stained with Hoechst (blue) and PI (red), respectively. The overlay of fluorescence images showed the high viability of cells. Scale bars: 100 µm.
Figures 19 and 20: Side view (Figure 19) and top view (Figure 20) of the formed cell aggregates. Scale bars: 50 µm.

The present invention will be further illustrated in the following examples without being limited thereto.

### Experimental procedures:

### General

Ammonium peroxodisulfate (98.0%, APS), N,N'-methylene bisacrylamide (99%, MBA), [2-(methacryloyloxy)ethyl]dimethyl-(3-sulfopropyl) ammonium hydroxide (97%, SAMA), Rhodamine B (95%), 3-(trimethoxysilyl)propyl methacrylate (98%), Gelatin, and fetal bovine serum (FBS) were purchased from Sigma-Aldrich (Germany). Dulbecco's Modified Eagle's Medium (DMEM), Penicillin/ Streptomycin, NEAA (100x Stock), phosphate-buffered saline (PBS), and trypsin/EDTA were purchased from Gibco Life Technologies GmbH (Germany). Poly(ethylene glycol) methyl ether methacrylate (Mn 500, PEG500MA), ethylene glycol dimethacrylate (98%, EGDMA), (hydroxyethyl)methacrylate (97%, HEMA), and poly(ethylene glycol) diacrylate (Mn 700, PEG700DA) were purchased from Sigma-Aldrich (Germany) and purified through a short column filled with basic aluminum oxide. *N,N,N',N'*-tetramethylethylenediamine (98.5 %, TEMED) was purchased from Carl Roth. Poly(ethylene glycol) dimethacrylate, (Mn 4000, PEG4000DMA) was synthesized according to the reported method. All the other chemicals were purchased from Merck KGaA (Germany) and used without further purification.

An OAI model 30 deep-UV collimated light source (San Jose, CA, USA) fitted with a 500 W HgXe lamp was utilized for high intensity UV irradiation. The lamp was calibrated to 5.0 mW/cm² at 260 nm with the OAI 306 UV power meter. The light source at 260 nm (5.0 mW/cm²) was used for UV irradiation unless otherwise specified. The fluorescence images were taken by a Keyence BZ-9000 fluorescence microscope (Japan). The 3D structures of hydrogel patterns were imaged using a Leica Confocal Microscope SPE. For photodegradation kinetics, Leica microscopy was used to measure the thickness of hydrogel block.

Rheological measurements were carried out on a ARES G2 rotational rheometer (TA Instruments, obtained from Waters GmbH, Eschborn, Germany) equipped with parallel plate Invar geometry (13 mm diameter) at a gap of 1.46 mm. Hydrogels were placed between two plates of the rheometer. An amplitude sweep (G' measured as a function of strain) was carried out to confirm that the measurements were performed within the linear viscoelastic regime. Oscillatory frequency sweeps were then conducted at 25°C with a constant strain of 1% in the frequency range of 100-0.1 rad s⁻¹.

### Example 1: Preparation of PEG500MA-EGDMA-10 hydrogel blocks

PEG500MA (2.32 mL) was dissolved in H₂O (10 mL), followed by the addition of EGDMA (106 µL) and TEMED (35.4 µL). This solution was vortexed as APS (27.2 mg) was added and quickly poured to one well (85.9 × 27.9 mm) of 4-well rectangular dish (NUNC). After gelation for 1 hour, the hydrogel block was carefully taken out and immersed into water. The hydrogel blocks were kept in water for at least 48 hours. During this period, the water was exchanged three times.

### Example 2: Preparation of PEG500MA-EGDMA-2.5 hydrogel blocks

PEG500MA- EGDMA-2.5 hydrogel blocks were prepared in accordance with Example 1 except that 2.4 mL of PEG500MA and 26 µL of EGDMA were used.

### Example 3: Preparation of PEG500MA-MBA-2.5 hydrogel blocks

PEG500MA-MBA-2.5 hydrogel blocks were prepared in accordance with Example 2 except that 20 mg of MBA were used instead of EGDMA.

### Example 4: Preparation of PEG500MA-PEG700DA-2.5 hydrogel blocks

PEG500MA-PEG700DA-2.5 hydrogel blocks were prepared in accordance with Example 1 except that 2.34 mL of PEG500MA were used and 82 µL of PEG700DA were used instead of EGDMA.

### Example 5: Preparation of PEG500MA-PEG4000DMA-0.17 hydrogel blocks

PEG500MA-PEG4000DMA-0.17 hydrogel blocks were prepared in accordance with Example 1 except that 2.38 mL of PEG500MA were used and 35 mg of PEG4000DMA were used instead of EGDMA.

### Examples 6 to 10: Hydrogel films with defined thickness

### General procedure

Two strips of 12.5 or 125 µm-thick Teflon film (American Durafilm Co.), defining the thickness of the hydrogel film, are placed at the edges of a 3-(trimethoxysilyl)propyl methacrylate functionalized glass slide and another tridecafluoro-(1,1,2,2)-tetrahydrooctyltrichlorosilane functionalized glass slide (cf. Levkin, P. et al, Angew. Chem. Int. Ed., 2011, 50, pp. 8424-8427) is clamped on top of it. 200 µL of the pregel solution was injected in the mold between them. After 1 hour, the obtained hydrogel film bound to the 3-(trimethoxysilyl)propyl methacrylate functionalized slide was separated from the fluorinated slide and kept in water overnight. Detailed pregel compositions for every hydrogel film are shown below.

### Example 6: Pregel composition of PEG500MA-EGDMA-10 hydrogel films

PEG500MA (232 µL) was dissolved in H₂O (1 mL), followed by the addition of EGDMA (10.6 µL) and TEMED (3.5 µL). This solution was vortexed as APS (2.7 mg) was added and immediately used for preparing hydrogel films.

### Example 7: Pregel composition of PEG500MA-PEG700DA-2.5 hydrogel films

PEG500MA (234 µL) was dissolved in H₂O (1 mL), followed by the addition of PEG700DA (8.2 µL) and TEMED (3.5 µL). This solution was vortexed as APS (2.7 mg) was added and immediately used for preparing hydrogel films.

### Example 8: Pregel composition of PEG500MA-PEG4000DMA-0.17 hydrogel films

PEG500MA (238 µL) was dissolved in H₂O (1 mL), followed by the addition of PEG4000DMA (3.5 mg) and TEMED (3.5 µL). This solution was vortexed as APS (2.7 mg) was added and immediately used for preparing hydrogel films.

### Example 9: Pregel composition of (HEMA_{80 mol%}-PEG500MA_{20 mol%})-EGDMA-2.5 hydrogel films

HEMA (119 µL) and PEG500MA (111 µL) was dissolved in H₂O (1 mL), followed by the addition of EGDMA (5.9 µL) and TEMED (3.5 µL). This solution was vortexed as APS (2.7 mg) was added and immediately used for preparing hydrogel films.

### Example 10: Pregel composition of SAMA-EGDMA-2.5 hydrogel films

SAMA (250 mg) was dissolved in H₂O (1 mL), followed by the addition of EGDMA (4.3 µL) and TEMED (3.5 µL). This solution was vortexed as APS (2.7 mg) was added and immediately used for preparing hydrogel films.

### Example 11: Rheology measurements and photodegradation experiments with the PEG500MA-EGDMA-10 hydrogel obtained in Example 6

The PEG500MA-EGDMA-10 hydrogel obtained in Example 6 was characterized with rheology measurement. As shown in Figure 2, the storage modulus (G') is frequency independent and more than one order of magnitude greater than the loss modulus (G"), indicating a crosslinked sample.

Then one 3.5 mm-thick block of this hydrogel was exposed to UV light (260 nm, 5 mW/cm²) and completely turned into liquid state after 25 min (Figure 3), which means this PEG500MA-EGDMA-10 hydrogel can be de-cross-linked under UV-irradiation.

Further rheology measurements were used to monitor the photodegradation process (Figure 4). During the UV irradiation, the G' of the hydrogel gradually decreased from 280 Pa to 84 Pa, being about 30 % of the original storage modulus (G'₀), during the exposure for 7 min (Figure 4). Longer irradiation leads to the total degradation of hydrogels. All these data supported the inherent photodegradability of a PEG500MA-EGDMA-10 hydrogel.

### Example 12: Investigation of the photodegradation process

For investigating the photodegradation process, PEG500MA-EGDMA-10 hydrogels were exposed to UV light for different times. Rhodamine B was non-specific absorbed into the hydrogel samples after UV irradiation in order to measure the thickness by confocal fluorescence microscopy. Due to the light absorption, the UV light intensity gradually decreased along the light path in the hydrogel. This attenuation led to the gradual decrease of degradation rate. Therefore, the uppermost layers of a thick hydrogel eroded faster under UV irradiation before the total degradation of underlying layers. In other words, this photodegradation should be a surface erosion process instead of a bulk erosion process.

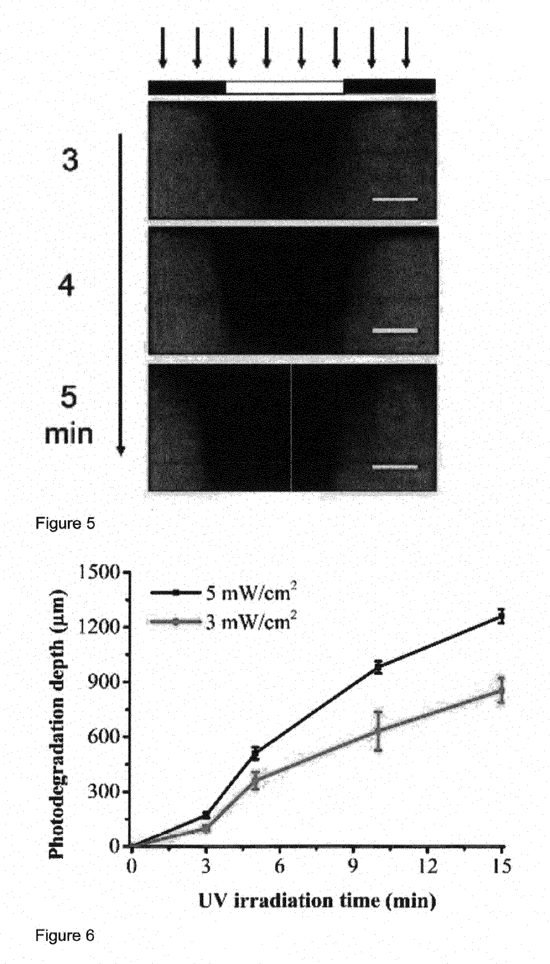

For demonstrating this hypothesis, the PEG500MA-EGDMA-10 hydrogel was locally irradiated with UV light and Rhodamine B physically encapsulated into the obtained samples for subsequent fluorescence imaging. As shown in Figure 5, masked irradiation of the hydrogel led to the degradation of hydrogels in the exposed areas and generated progressively recessed features, whereas hydrogels in the unexposed regions remained intact. This surface erosion process allows the fabrication of precise 3D microstructures, like microwells or microchannels, within hydrogels/organogels without sacrificing the mechanical supporting of bulk hydrogels/organogels, which is useful to prepare micro-devices.

### Example 13: Examination of the photodegradation kinetics

For quantitatively examining the photodegradation kinetics, different hydrogels were exposed to flood irradiation for different times and their erosion depths were measured with confocal fluorescence microscopy.

For examining the photodegradation kinetics of PEG500MA hydrogels, the corresponding blocks of Examples 1 to 5 were exposed to 260 nm light at certain intensities for different periods of time. After washing with water, the thicknesses of the hydrogels were measured with Leica microscopy. The photodegradation depth was determined as the difference between the original thickness and the final thickness after UV irradiation.

For HEMA and SAMA hydrogels with slow photodegradation kinetics, the respective films of Examples 9 and 10 with the thickness of 125 µm were exposed to 260 nm light through a photomask for different periods of time. After removing the photomask, the hydrogel film was washed with water. For introducing the dye for fluorescence imaging, the obtained hydrogel was immersed in an aqueous solution of Rhodamine B for 15 min, washed with water, and then characterized with confocal microscopy. The photodegradation depth was determined as the difference between the thickness of unexposed area and the thickness of exposed area.

### Variation in light intensity when irradiating PEG500MA-EGDMA-10 hydrogels

For quantitatively examining the photodegradation kinetics, the PEG500MA-EGDMA-10 hydrogels were exposed to flood irradiation for different times and their erosion depths were measured with microscopy. As sown in Figure 6, the photodegradation depth progressively increased with the irradiation time, and UV exposure at a higher intensity led to faster erosion kinetics. In detail, UV irradiation for 15 minutes at 3 mW/cm² generated the erosion of 850 µm-thick hydrogel while the same irradiation at 5 mW/cm² created the erosion of 1250 µm-thick hydrogel. Thus, for a photodegradable hydrogel with a fixed composition, an exactly defined photodegradation depth can be controlled by adjusting the UV exposure time. Moreover, erosion kinetics can be tailor-made by selecting the appropriate UV intensity.

### Variation in the nature and the ratio of the cross-linking agent

For examining the effects of the nature and the ratio of the cross-linking agent on the photodegradation kinetics, hydrogels with different cross-linking agents and differing cross-linking ratios were prepared and investigated.

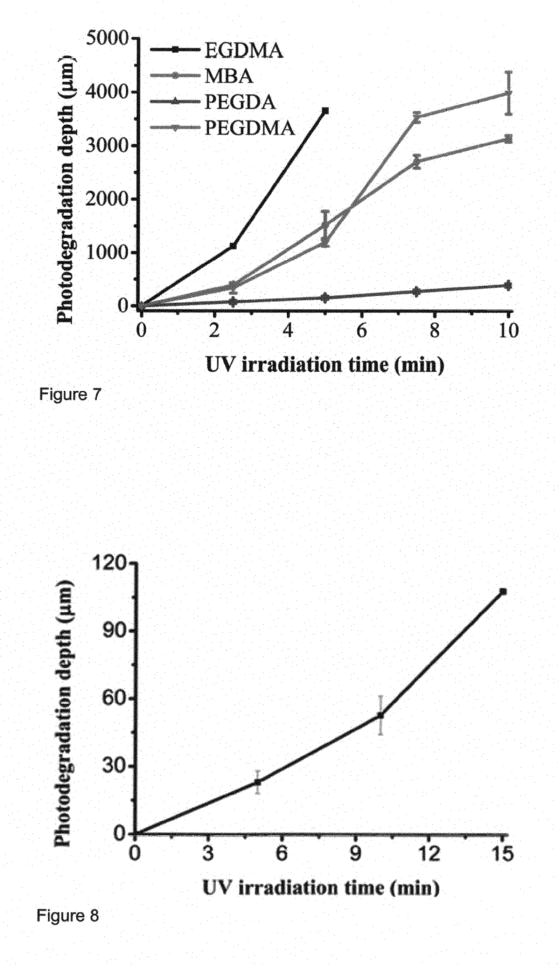

5 min UV irradiation (5 mW/cm²) led to the erosion depth of 3.65 mm for PEG500MA-EGDMA-2.5 (Figure 7), compared to 0.5 mm for PEG500MA-EGDMA-10 (Figure 6). Thus, faster degradation was achieved by reducing the ratio of the cross-linking agent EGDMA from 10 mol% to 2.5 mol%.

For testing the effects of the chemistry of the cross-linking agent on the photodegradation kinetics, hydrogels were prepared by copolymerizing PEG500MA with different cross-linking agents: N,N'-methylenebisacrylamide (MBA), poly(ethylene glycol) diacrylate (Mn 700, PEG700DA) and poly(ethylene glycol) dimethacrylate (Mn 4000, PEG4000DMA). Under fixed gelation and irradiation conditions and with the same ratio of cross-linking agent to monomer, the PEG500MA-PEG700DA-2.5 hydrogel showed the slowest degradation with an erosion depth of 150 µm at 5 min, which was 1500 µm for PEG500MA-MBA-2.5 hydrogel and 3650 µm for PEG500MA-EGDMA-2.5 hydrogel (Figure 7).

Without being bound to a specific theory, apparently, cross-linking agents with better water solubility and longer chain-length led to hydrogels with higher cross-linking degree, which required more UV energy for achieving the de-cross-linking of networks. This hypothesis is also supported by the fact that PEG500MA-PEG4000DMA-2.5 showed less degradation after 10 min. However, comparable degradation kinetics were observed when the ratio of PEG4000DMA was reduced to 0.17 mol%.

### HEMA and SAMA hydrogels

For investigating as to whether hydrogels composed of other methacrylate monomers can also be photodegraded, HEMA and SAMA hydrogels were studied. In detail, (HEMA80mol%-PEG500MA20mol%)-EGDMA-0.85 hydrogel and SAMA-EGDMA-2.5 hydrogel were tested. Both hydrogels possess the photodegradation property, show defined erosion kinetics, and also allow the photofabrication technique (cf. Figures 8, 9, 11, and 12). Therefore, this strategy promises a general way for the design of photodegradable hydrogels and hence provides a convenient way for the fabrication of 3D microstructures with adjusted chemistry.

### Example 14: Patterning hydrogels via photolithography techniques

In this process, the geometry of patterned hydrogels is defined by the used photomask and the thickness of eroded regions is determined by the exposure time and the original thickness. The model PEG500MA-EGDMA-10 hydrogel film of Example 6 with a thickness of 125 µm was subjected to UV light through different photomasks. Herein, all samples are subjected to an irradiation of 5 min at an intensity of 5 mW/cm², ensuring the complete degradation of exposed regions of hydrogel. After the washing with water and the encapsulation of Rhodamine B via subsequent immersion in a corresponding aqueous solution (20 µg/mL Rhodamine B) for 15 min and further washing with water, these patterned hydrogels were characterized with fluorescence microscopy and confocal microscopy.

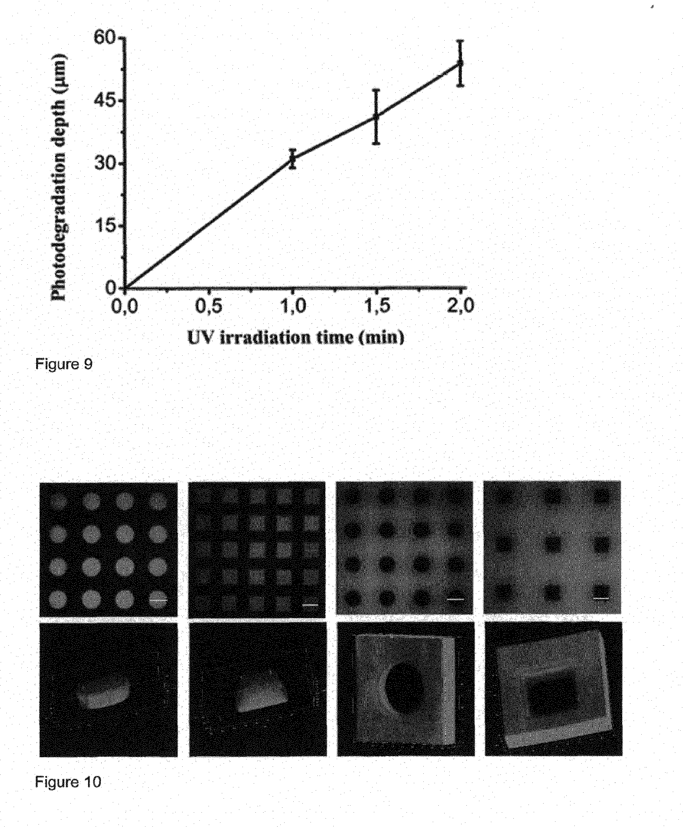

In Figure 10, the bright spots indicate the intact non-exposed hydrogels, while the dark regions confirm the complete degradation of exposed hydrogels. The obtained hydrogel pattern is consistent with the used photomask. The corresponding 3D shape is confirmed by the confocal image and its thickness is about 200 µm (due to the swelling effect of hydrogels). Microcavities were also imported within these photodegradable hydrogels by using appropriate photomasks. Other features of arbitrary shapes and sizes can be precisely and rapidly prepared with these photodegradable hydrogels/organogels.

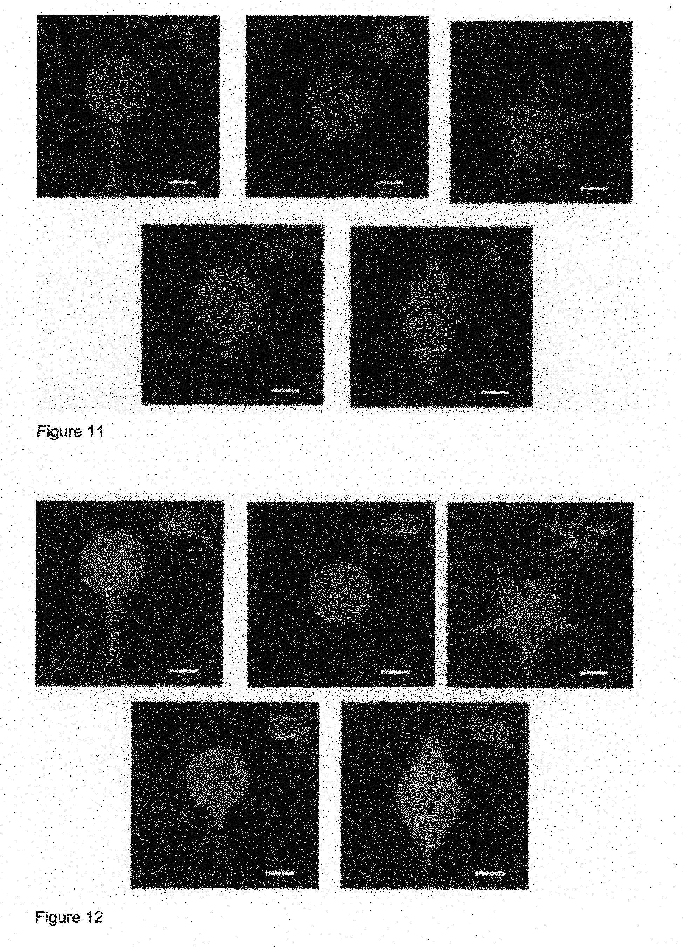

Corresponding hydrogel patterns of different geometries were also fabricated through corresponding photomasks from 125 µm-thick (HEMA80m%-PEG500MA20m%)-EGDMA-0.85 hydrogels and 125 µm-thick SAMA-EGDMA-2.5 hydrogels via UV irradiation (cf. Figures 11 and 12).

### Investigation concerning the resolution

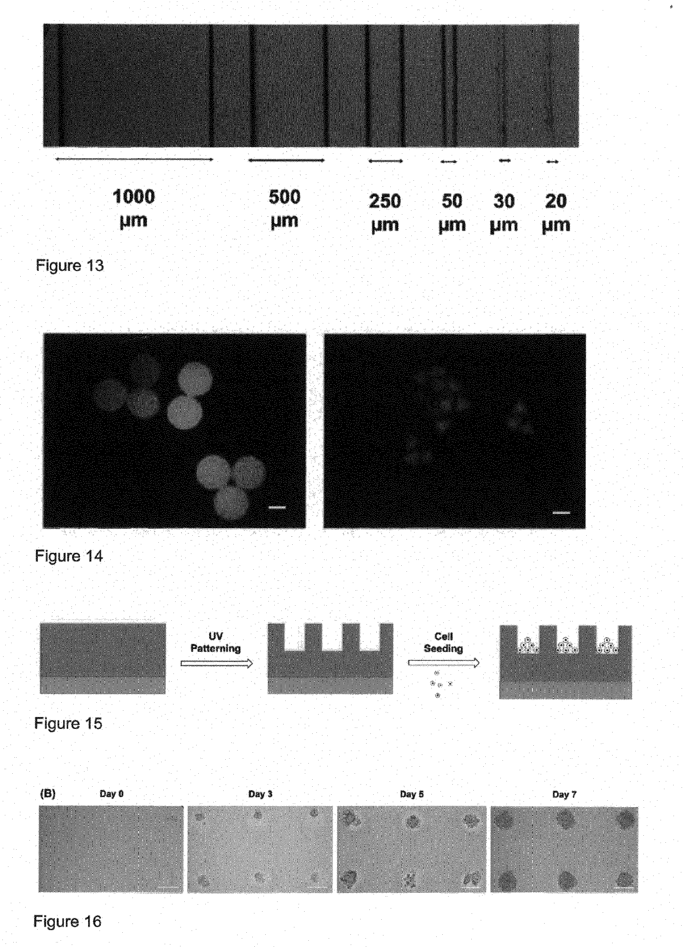

For investigating the resolution of this photofabrication technique, a 12.5 µm-thick PEG500MA-EGDMA-10 hydrogel of Example 6 was patterned with different feature sizes. As shown in Figure 13, a micropattern with a resolution of 20 µm could be fabricated.

### Preparation of free-standing hydrogel particles

A PEG500MA-PEG4000DMA-0.17 hydrogel film of Example 8 was prepared on the glass slide without methacrylated modification as described in the general procedure for Examples 6 to 10 to ensure the detachment of the hydrogel from the substrate. For fluorescent imaging, Rhodamine B (20 µg/mL) was added to the pregel solution. Its film with the thickness of 125 µm was prepared according to the above procedure. Then it was exposed to UV light through the photomask for 5 min. After removing the photomask, subsequent washing of the patterned hydrogel film gave free-standing microscale hydrogel particles (Figure 14). Thus, with this photopatterning technique, it is also possible to fabricate free-standing microscale hydrogel/organogel particles with different geometries by patterning these hydrogels/organogels without covalent bonding to the surface. In fact, these particles keep the photodegradation property. Accordingly, these particles could be used as remote-triggered sacrificial templates for microscale fabrications.

### Example 15: Fabrication of 3D microwell array systems

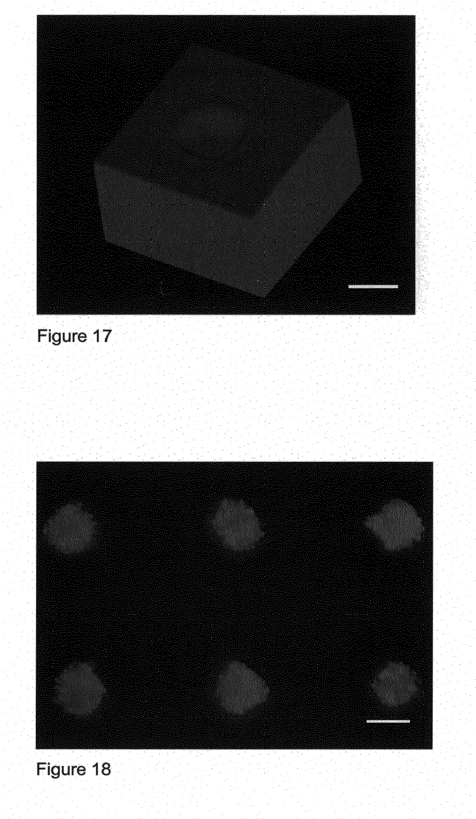

Via the photopatterning of a PEG500MA hydrogel, cell-repellent cylindrical microwell arrays were prepared, which promote cell aggregation (Figure 15). For preparing the microwell array, the PEG500MA-PEG700DA-2.5 hydrogel of Example 7 was used due to its controlled degradation kinetics. Its film with the thickness of 125 µm was exposed to UV light (260 nm, 4 mW/cm²) through a photomask for 5 min. After washing with water, the 3D microwell array was obtained and stored in H₂O for use. Figure 17 shows the 3D structure of microwells with the depth 60 µm and the diameter 100 µm. Both the periphery and the bottom of each microwell are cell-repellent PEG hydrogel, which promotes cell-cell contacts and thus multi-cellular aggregate formation.

### Example 16: Using fabricated 3D microwell array system of Example 15 for culturing cells

### Cell culture

Hela cells were cultured in complete Dulbecco's Modified Eagle's Medium (DMEM) containing 10% of fetal bovine serum (FBS) and 1% penicillin-streptomycin at pH 7.4. Cells were grown in 75cm² tissue culture flasks and incubated at 37°C in a humidified air atmosphere of 5% CO₂. Fresh medium was added every 2 to 3 days.

### Seeding cells into microwell array systems

For sterilization, the Microwell Array System was kept in ethanol for 20 min. Then it was immersed in PBS (phosphate buffered saline) for 60 min, and every 20 min the PBS was refreshed. This array was kept in cell culture medium for 20 min. Then, the array was placed in a 10 mL Petri dish.

Hela cells as model cell type were seeded into the microwells by adding 250 µL of cell suspension having a concentration of 10⁵ cells/mL on top of the microwell array. The cells were allowed to settle for 5 minutes into the microwells. The cells that did not sink into the microwells were gently washed away with PBS. A low density of cells (≈7 cells/microwell) were used in this experiment to permit the direct observation and monitoring of cell proliferation. Then Hela cells seeded on microwell arrays were cultured for 7 days in an incubator. The medium was changed at 3-day intervals. During the culture period, Brightfield images were recorded to investigate the distribution and proliferation of cells on the array and also visualize the morphologies of cell aggregates in the microwells (Figure 16).

During this period, the observed increase in cell density indicates the cell proliferation and demonstrates the good cytocompatibility of this hydrogel. Beginning from day 3, the Hela cells began to aggregate in each microwell due to the resistance of the PEG hydrogel to cell adhesion. After 7 days in culture, Hela cells grew to fill the size of the microwells and formed into relatively uniform cell aggregates. The hydrogel microwell array kept intact over 7 days. Cell viabilities were assessed by staining dead cells with propidium iodide (PI) for 20 minutes according to standard protocols. At the same time, cell nuclei were stained with Hoechst for 20 minutes according to standard protocols. Then the stained cells were imaged by fluorescence microscopy and confocal microscopy.

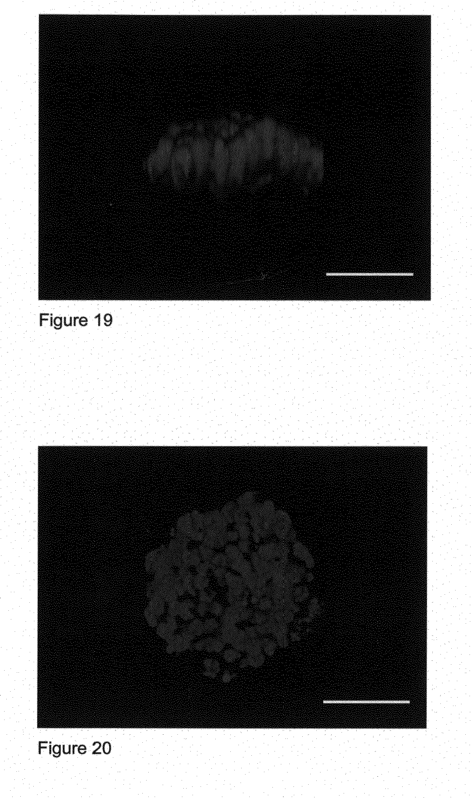

As shown in Figure 18, very few cells are stained red, indicating high viability of the cells throughout this culture period. Confocal fluorescent images in Figures 19 and 20 confirmed the compact 3D structure of cell aggregates, whose diameter and height scaled in size with the microwell dimension. The uniform cell aggregates are not limited to cylindrical shapes. Other geometries are also easily accessible by culturing cells in microwells with corresponded patterns, which are obtainable due to the great flexibility of the microfabrication based on the photodegradable hydrogels or organogels used in the present invention. In fact, cuboid Hela cell aggregates were successfully formed with controlled size and also high viability. These size-controlled cell aggregates could be useful for in vitro high throughput studies of tumor development as well as in drug screening studies.

## Claims

1. Use of a photodegradable hydrogel or organogel for manufacturing a patterned article by irradiating at least a part of the photodegradable hydrogel or organogel with UV light, the photodegradable hydrogel or organogel comprising a polymer including a three-dimensional network of cross-linked polymer chains,
the polymer chains having repeating units of the general Formula (I) 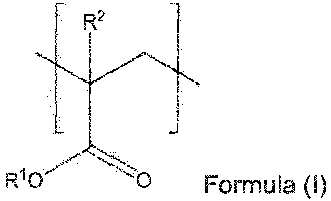
wherein each R¹ is independently selected from the group consisting of a substituted or unsubstituted 2-hydroxyethyl group, a substituted or unsubstituted 2-(N-3-sulfopropyl-N,N-dimethyl ammonium)ethyl group, and a substituted or unsubstituted poly(ethylene glycol) alkyl ether group selected from a PEG106 to PEG20000 group; and
each R² is independently a hydrogen atom or a substituted or unsubstituted alkyl group; and
wherein the photodegradable hydrogel or organogel does not comprise external photosensitive groups, photoinitiators or thiols.

2. Method for degrading a photodegradable hydrogel or organogel comprising the step of
irradiating at least a part of the photodegradable hydrogel or organogel with UV light;
wherein the photodegradable hydrogel or organogel comprises a polymer including a three-dimensional network of cross-linked polymer chains,
the polymer chains having repeating units of the general Formula (I) 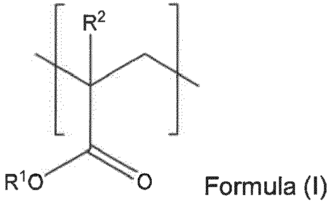
wherein each R¹ is independently selected from the group consisting of a substituted or unsubstituted 2-hydroxyethyl group, a substituted or unsubstituted 2-(N-3-sulfopropyl-N,N-dimethyl ammonium)ethyl group, and a substituted or unsubstituted poly(ethylene glycol) alkyl ether group selected from a PEG106 to PEG20000 group; and
each R² is independently a hydrogen atom or a substituted or unsubstituted alkyl group; and
wherein the photodegradable hydrogel or organogel does not comprise external photosensitive groups, photoinitiators or thiols.

3. The use according to claim 1 or the method according to claim 2, wherein the polymer is obtained by polymerizing monomer units of the general Formula (II) 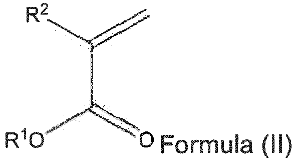 in the presence of a cross-linking agent,
wherein each R¹ is independently selected from the group consisting of a substituted or unsubstituted 2-hydroxyethyl group, a substituted or unsubstituted 2-(N-3-sulfopropyl-N,N-dimethyl ammonium)ethyl group, and a substituted or unsubstituted poly(ethylene glycol) alkyl ether group selected from a PEG106 to PEG20000 group; and
each R² is independently a hydrogen atom or a substituted or unsubstituted alkyl group.

4. The use or the method according to any one of the preceding claims, wherein each R¹ independently is a poly(ethylene glycol) alkyl ether group selected from a PEG106 to PEG20000 group.

5. The use or the method according to any one of the preceding claims, wherein R² is a methyl group.

6. The use or the method according to any one of the preceding claims, wherein the cross-linking agent used for cross-linking the polymer chains has the general Formula (III) 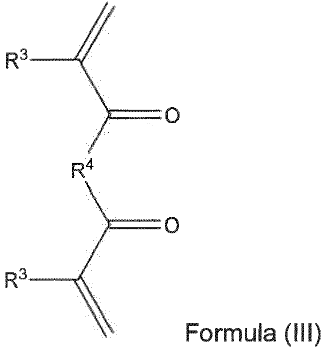
wherein each R³ is independently selected from the group consisting of a hydrogen atom, a substituted or unsubstituted alkyl group, a substituted or unsubstituted cycloalkyl group, a substituted or unsubstituted aryl group, and a substituted or unsubstituted heteroaryl group; and
R⁴ is selected from a substituted or unsubstituted alkylene group, a substituted or unsubstituted poly(ethylene glycol) linker group, and the following Formula (IV) 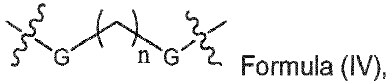 wherein G is NH or an oxygen atom and n is an integer from 1 to 5.

7. The use or the method according to claim 6, wherein cross-linking agent is selected from the group consisting of ethylene glycol dimethacrylate (EGDMA), *N*,*N*'-methylenebisacrylamide (MBA), poly(ethylene glycol) diacrylate selected from PEG106DA to PEG20000DA, and poly(ethylene glycol) dimethacrylate selected from PEG106DMA to PEG20000DMA.

8. The use or the method according to any one of the preceding claims, wherein the content of the polymer in the hydrogel or organogel is from 2.0 to 40 wt%.

9. The use or the method according to any one of the preceding claims, wherein the mole fraction of the cross-linker used is from 0.10 to 20% based on the total amount of the monomer units and the cross-linker.

10. The use or the method according to any one of the preceding claims, wherein the light has an intensity from 0.1 mW/cm² to 1000 mW/cm².

11. The use or the method according to any one of the preceding claims, wherein the hydrogel or organogel is irradiated for 30 s to 2.5 h.

12. Patterned article obtained by the use or the method according to any one of the preceding claims.

13. The patterned article according to claim 12, wherein the patterned article is a microwell array, a complex three-dimensional structure, or a particle.

14. Use of the patterned article according to claim 12 for three-dimensional cell culturing, for drug delivery, or for tissue-engineering.

## Patentansprüche

1. Verwendung eines photoabbaubaren Hydrogels oder Organogels zur Herstellung eines strukturierten Gegenstandes durch das Bestrahlen mindestens eines Teils des photoabbaubaren Hydrogels oder Organogels mit UV-Licht, wobei das photoabbaubare Hydrogel oder Organogel ein Polymer, das ein dreidimensionales Netzwerk aus vernetzten Polymerketten einschließt, umfasst, wobei die Polymerketten sich wiederholende Einheiten der allgemeinen Formel (I) aufweisen 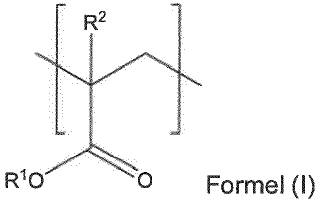
wobei jedes R¹ unabhängig ausgewählt ist aus der Gruppe, bestehend aus einer substituierten oder unsubstituierten 2-Hydroxyethylgruppe, einer substituierten oder unsubstituierten 2-(N-3-Sulfopropyl-N,N-dimethylammonium)ethylgruppe und einer substituierten oder unsubstituierten Poly(ethylenglykol)alkylether-gruppe, ausgewählt aus einer PEG106- bis PEG20000-Gruppe; und
jedes R² unabhängig ein Wasserstoffatom oder eine substituierte oder unsubstituierte Alkylgruppe ist; und
wobei das photoabbaubare Hydrogel oder Organogel keine externen photoempfindlichen Gruppen, Photoinitiatoren oder Thiole umfasst.

2. Verfahren zum Abbau eines photoabbaubaren Hydrogels oder Organogels, umfassend den Schritt
des Bestrahlens mindestens eines Teils des photoabbaubaren Hydrogels oder Organogels mit UV-Licht;
wobei das photoabbaubare Hydrogel oder Organogel ein Polymer, das ein dreidimensionales Netzwerk aus vernetzten Polymerketten einschließt, umfasst, wobei die Polymerketten sich wiederholende Einheiten der allgemeinen Formel (I) aufweisen 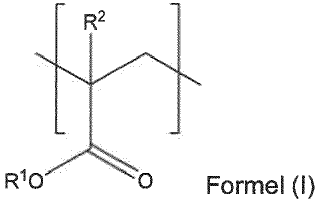
wobei jedes R¹ unabhängig ausgewählt ist aus der Gruppe, bestehend aus einer substituierten oder unsubstituierten 2-Hydroxyethylgruppe, einer substituierten oder unsubstituierten 2-(N-3-Sulfopropyl-N,N-dimethylammonium)ethylgruppe und einer substituierten oder unsubstituierten Poly(ethylenglykol)alkylether-gruppe, ausgewählt aus einer PEG106- bis PEG20000-Gruppe; und
jedes R² unabhängig ein Wasserstoffatom oder eine substituierte oder unsubstituierte Alkylgruppe ist; und
wobei das photoabbaubare Hydrogel oder Organogel keine externen photoempfindlichen Gruppen, Photoinitiatoren oder Thiole umfasst.

3. Verwendung nach Anspruch 1 oder Verfahren nach Anspruch 2, wobei das Polymer erhalten wird durch das Polymerisieren von Monomereinheiten der allgemeinen Formel (II) 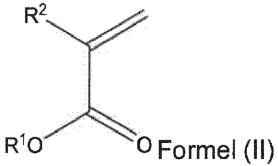 in Gegenwart eines Vernetzungsmittels,
wobei jedes R¹ unabhängig ausgewählt ist aus der Gruppe, bestehend aus einer substituierten oder unsubstituierten 2-Hydroxyethylgruppe, einer substituierten oder unsubstituierten 2-(N-3-Sulfopropyl-N,N-dimethylammonium)ethylgruppe und einer substituierten oder unsubstituierten Poly(ethylenglykol)alkylether-gruppe, ausgewählt aus einer PEG106- bis PEG20000-Gruppe; und
jedes R² unabhängig ein Wasserstoffatom oder eine substituierte oder unsubstituierte Alkylgruppe ist.

4. Verwendung oder Verfahren nach einem der vorstehenden Ansprüche, wobei jedes R¹ unabhängig voneinander eine Poly(ethylenglykol)alkylethergruppe, ausgewählt aus einer PEG106- bis PEG20000-Gruppe, ist.

5. Verwendung oder Verfahren nach einem der vorstehenden Ansprüche, wobei R² eine Methylgruppe ist.

6. Verwendung oder Verfahren nach einem der vorstehenden Ansprüche, wobei das zur Vernetzung der Polymerketten verwendete Vernetzungsmittel die allgemeine Formel (III) aufweist 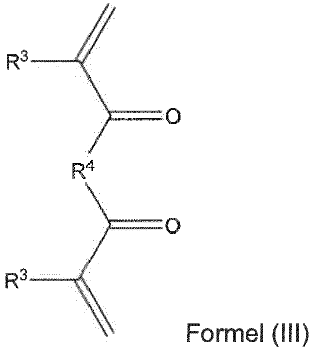
wobei jedes R³ unabhängig ausgewählt ist aus der Gruppe, bestehend aus einem Wasserstoffatom, einer substituierten oder unsubstituierten Alkylgruppe, einer substituierten oder unsubstituierten Cycloalkylgruppe, einer substituierten oder unsubstituierten Arylgruppe und einer substituierten oder unsubstituierten Heteroarylgruppe; und
R⁴ ausgewählt ist aus einer substituierten oder unsubstituierten Alkylengruppe, einer substituierten oder unsubstituierten Poly(ethylenglykol)-Linkergruppe und der folgenden Formel (IV) 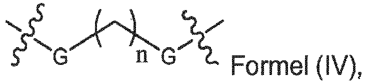 wobei G NH oder ein Sauerstoffatom ist und n eine ganze Zahl von 1 bis 5 ist.

7. Verwendung oder Verfahren nach Anspruch 6, wobei das Vernetzungsmittel ausgewählt ist aus der Gruppe, bestehend aus Ethylenglykoldimethacrylat (EGDMA), N,N'-Methylenbisacrylamid (MBA), Poly(ethylenglykol)diacrylat, ausgewählt aus PEG106DA bis PEG20000DA, und Poly(ethylenglykol)dimethacrylat, ausgewählt aus PEG106DMA bis PEG20000DMA.

8. Verwendung oder Verfahren nach einem der vorstehenden Ansprüche, wobei der Gehalt des Polymers in dem Hydrogel oder Organogel von 2,0 bis 40 Gew.-% beträgt.

9. Verwendung oder Verfahren nach einem der vorstehenden Ansprüche, wobei der Molenbruch des verwendeten Vernetzungsmittels von 0,10 bis 20 %, bezogen auf die Gesamtmenge der Monomereinheiten und des Vernetzungsmittels, beträgt.

10. Verwendung oder Verfahren nach einem der vorstehenden Ansprüche, wobei das Licht eine Intensität von 0,1 mW/cm² bis 1000 mW/cm² aufweist.

11. Verwendung oder Verfahren nach einem der vorstehenden Ansprüche, wobei das Hydrogel oder Organogel für 30 s bis 2,5 h bestrahlt wird.

12. Strukturierter Gegenstand, erhalten durch die Verwendung oder das Verfahren nach einem der vorstehenden Ansprüche.

13. Strukturierter Gegenstand nach Anspruch 12, wobei der strukturierte Gegenstand ein Mikrotiterplatten-Array, eine komplexe dreidimensionale Struktur oder ein Teilchen ist.

14. Verwendung des strukturierten Gegenstandes nach Anspruch 12 zur dreidimensionalen Zellkultivierung, zur Verabreichung von Medikamenten oder zum Tissue-Engineering.

## Revendications

1. Utilisation d'un hydrogel ou organogel photodégradable pour la préparation d'un article à motifs par irradiation d'au moins une partie de l'hydrogel ou organogel photodégradable par de la lumière UV, l'hydrogel ou organogel photodégradable comprenant un polymère incluant un réseau tridimensionnel de chaines polymères réticulées, les chaines polymères ayant des unités récurrentes de la formule générale (I) 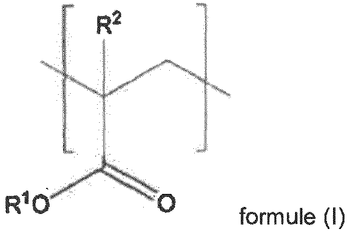
dans laquelle chacun des R¹ est indépendamment choisi parmi le groupe consistant en un groupe 2-hydroxyéthyle substitué ou non substitué, un groupe 2-(N-3-sulfopropyl-N,N-diméthylammonium)éthyle substitué ou non substitué, et un groupe poly(éthylèneglycol)alkyléther substitué ou non substitué choisi parmi un groupe PEG106 à PEG20000 ; et
chaque R² est indépendamment un atome d'hydrogène ou un groupe alkyle substitué ou non substitué, et
dans lequel l'hydrogel ou organogel photodégradable ne comprend pas de groupes photosensibles externes, ni de photoinitiateurs, ni de thiols.

2. Procédé de dégradation d'un hydrogel ou organogel photodégradable, comprenant les étapes de
irradiation d'au moins une partie de l'hydrogel ou organogel photodégradable avec de la lumière UV ;
dans lequel l'hydrogel ou organogel photodégradable comprend un polymère incluant un réseau tridimensionnel de chaines polymères réticulées, les chaines polymères ayant des unités récurrentes de la formule générale (I) 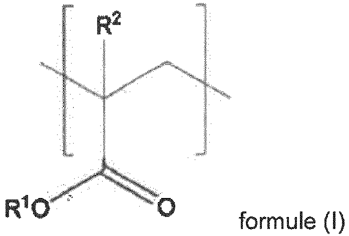
dans laquelle chacun des R¹ est indépendamment choisi parmi le groupe consistant en un groupe 2-hydroxyéthyle substitué ou non substitué, un groupe 2-(N-3-sulfopropyl-N,N-diméthylammonium)éthyle substitué ou non substitué, et un groupe poly(éthylèneglycol)alkyléther substitué ou non substitué choisi parmi un groupe PEG106 à PEG20000 ; et
chaque R² est indépendamment un atome d'hydrogène ou un groupe alkyle substitué ou non substitué ; et
dans lequel l'hydrogel ou organogel photodégradable ne comprend pas de groupes photosensibles externes, ni de photoinitiateurs, ni de thiols.

3. Utilisation selon la revendication 1 ou procédé selon la revendication 2, dans lequel le polymère est obtenu par polymérisation d'unités monomères de la formule générale (II) 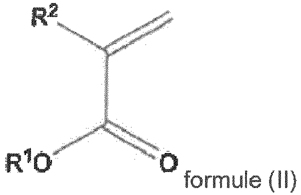 en présence d'un agent de réticulation,
dans laquelle chacun des R¹ est indépendamment choisi parmi le groupe consistant en un groupe 2-hydroxyéthyle substitué ou non substitué, un groupe 2-(N-3-sulfopropyl-N,N-diméthylammonium)éthyle substitué ou non substitué, et un groupe poly(éthylèneglycol)alkyléther substitué ou non substitué choisi parmi un groupe PEG106 à PEG20000 ; et
chaque R² est indépendamment un atome d'hydrogène ou un groupe alkyle substitué ou non substitué.

4. Utilisation ou procédé selon l'une quelconque des revendications précédentes, dans lequel chaque R¹ est indépendamment, un groupe poly(éthylèneglycol)alkyléther choisi parmi un groupe PEG106 à PEG20000.

5. Utilisation ou procédé selon l'une quelconque des revendications précédentes, dans lequel R² est un groupe méthyle.

6. Utilisation ou procédé selon l'une quelconque des revendications précédentes, dans lequel l'agent de réticulation utilisé pour la réticulation des chaines polymères a la formule générale (III) 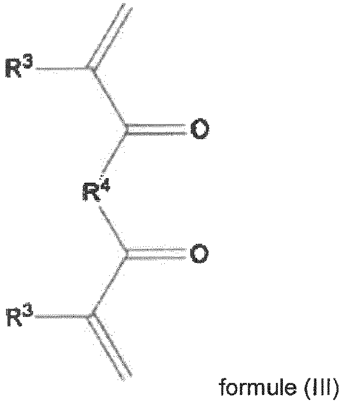
dans laquelle chaque R³ est indépendamment choisi parmi le groupe consistant en un atome d'hydrogène, un groupe alkyle substitué ou non substitué, un groupe cycloalkyle substitué ou non substitué, un groupe aryle substitué ou non substitué, et un groupe hétéroaryle substitué ou non substitué ; et
R⁴ est choisi parmi un groupe alkylène substitué ou non substitué, un groupe lieur poly(éthylèneglycol) substitué ou non substitué, et la formule (IV) suivante 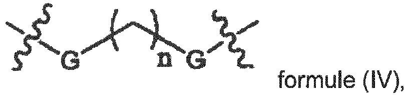 dans laquelle G est NH ou un atome d'oxygène et n est un entier allant de 1 à 5.

7. Utilisation ou procédé selon la revendication 6, dans lequel l'agent de réticulation est choisi parmi le groupe consistant en le diméthacrylate d'éthylèneglycol (EGDMA), le N,N'-méthylènebisacrylamide (MBA), le diacrylate de poly(éthylèneglycol) choisi parmi le PEG106DA au PEG20000DA, et le diméthacrylate de poly(éthylèneglycol) choisi parmi le PEG106DMA au PEG20000DMA.

8. Utilisation ou procédé selon l'une quelconque des revendications précédentes, dans lequel la teneur en polymère dans l'hydrogel ou l'organogel se situe dans l'intervalle allant de 2,0 à 40% en poids.

9. Utilisation ou procédé selon l'une quelconque des revendications précédentes, dans lequel la fraction molaire de l'agent de réticulation utilisé se situe dans l'intervalle allant de 0,10 à 20% sur base de la quantité totale d'unités monomères et de l'agent de réticulation.

10. Utilisation ou procédé selon l'une quelconque des revendications précédentes, dans lequel la lumière a une intensité située dans l'intervalle allant de 0,1 mW/cm² et 1000 mW/cm².

11. Utilisation ou procédé selon l'une quelconque des revendications précédentes, dans lequel l'hydrogel ou organogel est irradié pendant 30 s à 2,5 heures.

12. Article à motifs obtenu par l'utilisation ou par le procédé selon l'une quelconque des revendications précédentes.

13. Article à motifs selon la revendication 12, dans lequel l'article à motifs est un réseau de micropuits, une structure tridimensionnelle complexe ou une particule.

14. Utilisation de l'article à motifs selon la revendication 12, pour la culture tridimensionnelle de cellules, pour l'administration d'un médicament, ou pour l'ingénierie tissulaire.
